# FASCICULE DE BREVET EUROPEEN

(11) **EP 0 585 150 B1**
(45) Date de publication et mention de la délivrance du brevet: **15.02.1995**
(21) Numéro de dépôt: 93401861.5
(22) Date de dépôt: 19.07.1993
(51) Int. Cl.: G11C 16/06, G11C 7/00

(54) **Circuit de lecture pour mémoire, avec précharge et équilibrage avant lecture**
Speicher-Leseschaltung mit Vorladung und Ausgleichung vor dem Lesen
Memory read circuit, with precharging and equilibrating before reading

(30) Priorité: 24.07.1992 FR 9209199
(43) Date de publication de la demande: 02.03.1994
(73) Titulaire: SGS-THOMSON MICROELECTRONICS S.A., 94250 Gentilly (FR)
(72) Inventeur: Gaultier, Jean-Marie, F-75116 Paris (FR); Yero, Emilio, F-75116 Paris (FR)
(74) Mandataire: Ballot, Paul Denis Jacques

(56) Documents cités:
- EP-A- 0 264 933
- EP-A- 0 412 837
- EP-A- 0 488 893
- IEEE JOURNAL OF SOLID-STATE CIRCUITS. vol. 23, no. 5 , Octobre 1988 , NEW YORK US pages 1150 - 1156 GASTALDI ET AL 'A 1-MBIT CMOS EPROM WITH ENHANCED VERIFICATION.' *

## Description

L'invention concerne les mémoires en circuit intégré, et plus particulièrement les circuits de lecture permettant de détecter l'état des cellules de la mémoire.

L'invention sera décrite en référence aux mémoires non volatiles électriquement programmables (EEPROM, EPROM, flash EPROM) bien qu'elle soit applicable à d'autres types de mémoire, volatiles ou non volatiles.

Les mémoires sont organisées en réseaux de cellules, les cellules d'une même colonne étant reliées à une ligne de bit et les cellules d'une même rangée étant reliées à une ligne de mot. La ligne de bit permet de transmettre une information sur l'état d'une cellule de mémoire située au croisement de cette ligne de bit et d'une ligne de mot sélectionnée.

Les circuits de lecture sont reliés aux lignes de bit, éventuellement par l'intermédiaire d'un multiplexeur s'il y a plusieurs lignes de bit pour un seul circuit de lecture. On considérera dans la suite la constitution d'un seul circuit de lecture, supposé relié à une seule ligne de bit, afin de simplifier les explications.

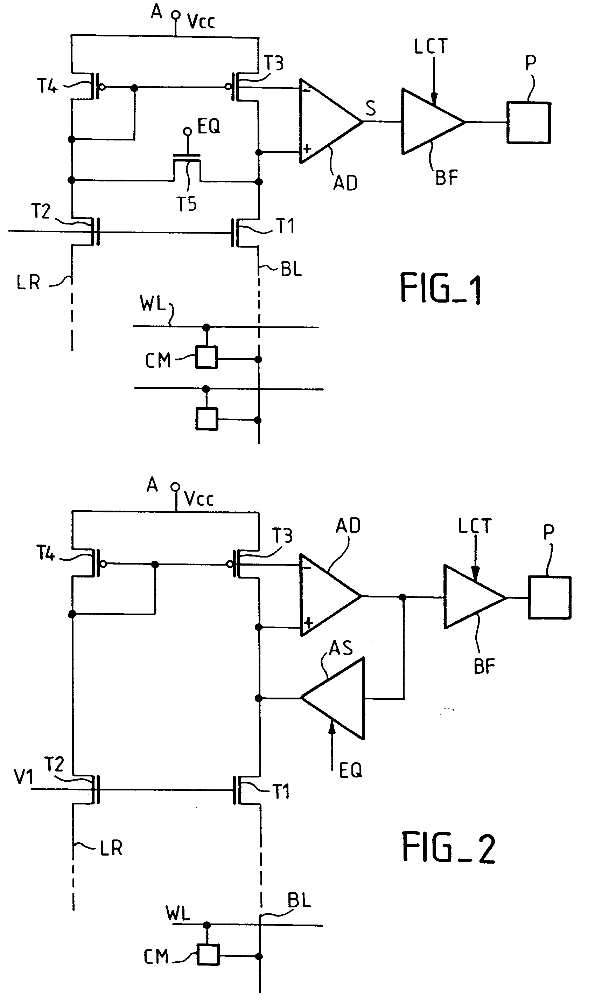

Le principe général d'un circuit de lecture est représenté à la figure 1 et son fonctionnement va être expliqué ci-après. On suppose que la mémoire est une mémoire EEPROM, les cellules pouvant avoir un état vierge, dans lequel elles peuvent laisser passer un courant électrique, et un état programmé, dans lequel elle s'opposent au passage du courant; pour lire l'information on cherche à détecter la présence d'un courant de charge ou de décharge de la ligne de bit reliée à une cellule à lire : un tel courant existe si la cellule est vierge, alors qu'il n'existe pas si la cellule est programmée.

Pour détecter le courant, on utilise une ligne de référence semblable à la ligne de bit, de manière à travailler en différentiel. La ligne de référence conduit un courant de référence pendant la phase de lecture. Dans une phase de précharge préalable à la phase de lecture, la ligne de bit et la ligne de référence sont préchargées à un potentiel qui peut être de l'ordre de 1 volt. Puis la phase de lecture proprement dite a lieu, et le courant de décharge de la ligne de bit est comparé au courant de décharge de la ligne de référence; cela permet de déterminer si la cellule sélectionnée est vierge ou programmée. De préférence un convertisseur courant/tension est utilisé pour convertir le courant de décharge de la ligne de bit en une tension de manière à pouvoir utiliser un amplificateur différentiel de tension pour effectuer la comparaison.

La figure 1 représente de manière simplifiée un exemple de circuit de lecture de l'art connu.

Une cellule mémoire CM, située au carrefour d'une ligne de mot WL et d'une ligne de bit BL peut être sélectionnée par la ligne de mot et délivre alors une information sur la ligne de bit. La ligne de bit BL est préchargée en tension, dans une phase de précharge, par un transistor de précharge T1 qui a pour fonction de fournir un courant de précharge à la ligne de bit, tout en limitant le potentiel de précharge à une valeur déterminée, de préférence aux alentours d'un volt.

Une ligne de référence LR, de caractéristiques très similaires à la ligne de bit, notamment du point de vue des capacités parasites, est également préchargée à une valeur de tension d'environ un volt par un transistor de précharge T2. Lors de la phase de lecture, cette ligne de référence consomme un courant équivalent à celui qui est consommé par une cellule de mémoire vierge. La ligne de référence peut être la ligne de bit d'une colonne de cellules de références vierges adressées par les mêmes lignes de mot que les cellules à lire.

Les transistors T1 et T2 sont de préférence à canal N, leur source est reliée à la ligne de bit et à la ligne de référence respectivement. Pour simplifier, les grilles des transistors T1 et T2 sont représentées comme reliées à une source de tension de polarisation V1. La valeur de la tension V1 définit la limite supérieure de la tension de précharge des lignes LR et BL.

Pour lire l'état des cellules, on va effectuer une comparaison entre le courant consommé par la ligne de bit et un courant de référence. Plus précisément, on va comparer le courant consommé par la ligne de bit à un courant de référence qui est une fraction du courant normalement consommé par une cellule vierge.

Pour cela, les drains des transistors T1 et T2 sont alimentés par les deux branches d'un miroir de courant de rapport de recopie k plus petit que 1. La première branche du miroir comprend un transistor de recopie T3; la deuxième branche comprend un transistor de référence T4. Le transistor de recopie tend à recopier le courant qui circule dans le transistor de référence. Le rapport de recopie k est le rapport des géométries des transistors et on s'arrange de préférence pour que ce rapport k soit inférieur à l'unité, par exemple 1/2.

Le transistor de recopie T3 est un transistor à canal P ayant sa source reliée à la borne de tension d'alimentation haute du circuit (borne A); celle-ci est en général à + 5 volts environ au dessus d'une borne d'alimentation basse. Le drain du transistor de recopie est relié au drain du premier transistor de précharge T1.

Le transistor de référence T4 est de la même façon un transistor à canal P, de géométrie plus grande que T3, dont la source est reliée à la borne A et dont le drain est relié au drain du deuxième transistor de précharge T2.

Les grilles des transistors T3 et T4 sont réunies et la grille du transistor de référence est reliée à son drain (montage en diode). On a donc un schéma classique de recopie de courant.

Un amplificateur différentiel AD a ses entrées reliées aux drains des transistors T3 et T4 et mesure donc l'écart entre les potentiels sur ces deux drains. Cet écart est nul si les courants dans T3 et T4 sont dans le rapport des géométries k. Il diffère de zéro si le rapport des courants diffère de k. La sortie de l'amplificateur AD fournit un signal qui indique si le rapport des courants est supérieur ou inférieur à k.

Enfin, un transistor d'équilibrage T5 est prévu pour mettre à zéro la tension d'entrée différentielle aux bornes de l'amplificateur différentiel, dans une phase d'équilibrage qui suit la phase de précharge et qui précède la phase de lecture. Cette phase d'équilibrage permet de ramener l'écart de tension différentielle à l'entrée de l'amplificateur AD a une valeur aussi proche que possible de zéro quel que soit l'état logique lu dans une cellule de mémoire à la phase de lecture précédente. Le transistor T5 est par exemple un transistor à canal N rendu conducteur pendant une phase d'équilibrage EQ.

Parmi les qualités qu'on attend d'un circuit de lecture, il y a notamment l'obtention d'une rapidité suffisante des phases de précharge, d'équilibrage et de lecture, qui est liée d'ailleurs à la sensibilité de la lecture, c'est-à-dire à la capacité du circuit à détecter de faibles variations de courant.

Pour améliorer les compromis entre les impératifs de rapidité et d'exactitude de l'information lue, la présente invention propose d'améliorer le circuit de lecture en modifiant le circuit d'équilibrage et sa relation avec le reste du circuit de lecture.

Selon l'invention, on propose une mémoire en circuit intégré, comprenant au moins une ligne de bit à laquelle sont raccordées des cellules de mémoire, et un circuit de lecture connecté à la ligne de bit et comprenant un amplificateur différentiel, des moyens de précharge de la ligne de bit avant une phase de lecture et des moyens d'équilibrage des potentiels d'entrée de l'amplificateur différentiel avant la phase de lecture, caractérisée en ce que les moyens d'équilibrage comportent un amplificateur suiveur ayant une entrée reliée à la sortie de l'amplificateur différentiel et connecté pendant la phase d'équilibrage, mais non pendant la phase de lecture, de telle manière qu'il injecte un courant de charge sur la ligne de bit dans un sens tendant à annuler la tension de sortie de l'amplificateur différentiel.

En d'autres mots, la phase d'équilibrage utilise non pas un simple court-circuit entre les entrées de l'amplificateur différentiel, pour équilibrer la précharge de la ligne de bit et la précharge de la ligne de référence afin d'avoir une tension différentielle nulle à l'entrée de l'amplificateur différentiel, mais elle utilise une contre-réaction entre la sortie de l'amplificateur et l'une des entrées, cette contre-réaction agissant sur la précharge de la ligne de bit.

Dans le cas général, il y aura une ligne de référence semblable à la ligne de bit, un premier transistor de précharge de la ligne de bit, un deuxième transistor de précharge de la ligne de référence, et la sortie de l'amplificateur suiveur sera connectée pendant la phase d'équilibrage au premier transistor de précharge.

En principe, la ligne de bit et la ligne de référence sont reliées à des moyens de comparaison de courant permettant de comparer, pendant la phase de lecture, le courant de décharge de la ligne de bit et le courant de décharge de la ligne de référence. Ces moyens de comparaison peuvent utiliser un miroir de courant à rapport de recopie différent de l'unité, avec un transistor de référence et un transistor de recopie.

Dans ce cas, il est souhaitable de prévoir un premier transistor intermédiaire ayant sa grille reliée à un potentiel fixe et relié en série entre le transistor de recopie et le premier transistor de précharge, et un deuxième transistor intermédiaire ayant sa grille reliée au même potentiel que le premier, en série entre le transistor de référence et le deuxième transistor de précharge. Ces transistors intermédiaires sont montés en cascode, avec leur grille à potentiel constant, et ils servent à augmenter la résistance dynamique des branches du miroir de courant, de manière à accélérer la détection d'une variation de courant dans les branches du miroir de courant.

Les caractéristiques et avantages de l'invention apparaîtront à la lecture de la description détaillée qui suit et qui est faite en référence aux dessins annexés dans lesquels :
- la figure 1, déjà décrite, représente un circuit de lecture d'une technique connue;
- la figure 2 représente un circuit de lecture selon un mode de réalisation de l'invention;
- la figure 3 représente un circuit de lecture selon une autre réalisation.

La figure 2 se différencie de la figure 1 en ce qu'on a supprimé le transistor d'équilibrage T5 et rajouté un amplificateur suiveur AS, dont l'entrée est reliée à la sortie S de l'amplificateur différentiel AD, et dont la sortie est reliée au drain de l'un des transistors de précharge, de préférence le transistor T1 qui est relié à la ligne de bit correspondant à la cellule à lire.

Cet amplificateur suiveur AS n'est activé que pendant une phase d'équilibrage EQ précédant la phase de lecture LCT. Pendant les autres phases, c'est-à-dire plus spécialement pendant la phase de lecture, sa sortie se comporte comme une haute impédance, de manière à ne pas prélever ou injecter de courant dans la première branche du miroir de courant. Une commande d'activation de l'amplificateur suiveur reçoit un signal d'horloge définissant la phase d'équilibrage EQ.

Cet amplificateur suiveur constitue l'élément principal d'une boucle de contre réaction qui modifie la précharge de la ligne de bit pour augmenter ou diminuer le potentiel d'une entrée de l'amplificateur différentiel AD, dans un sens tendant à annuler la tension de sortie de l'amplificateur différentiel.

Cette boucle de contre réaction tend donc à jouer le rôle qu'on cherche à faire jouer au transistor T5 dans la figure 1, mais d'une manière très différente puisque d'une part on agit directement à partir de la sortie de l'amplificateur différentiel et non de ses entrées, et d'autre part on agit en injectant ou retranchant un courant supplémentaire de charge de la ligne de bit et non pas en court-circuitant la ligne de bit et la ligne de référence.

On peut considérer que l'activation de l'amplificateur suiveur AS agit comme une précharge complémentaire, de sorte qu'il n'est même pas forcément nécessaire de prévoir deux phases distinctes (précharge et équilibrage) avant la phase de lecture; une phase d'équilibrage unique peut être prévue puisqu'elle agit de la même manière qu'une phase de précharge tout en assurant la fonction d'équilibrage.

C'est pourquoi on a représenté les grilles de commande de T1 et T2 commandées par un simple potentiel de polarisation fixe V1 et non pas par un circuit activé pendant une phase de précharge. Par exemple V1=2 volts pour limiter le potentiel des lignes LR et BL à environ 1 volt.

Les transistors T1 et T2 agissent, comme à la figure 1, comme limiteurs de tension pour limiter la tension de précharge de la ligne de bit et de la ligne de référence aux alentours de 1 volt.

Le circuit fonctionne de la manière suivante pendant la phase de précharge la ligne de bit et la ligne de référence sont portées à un potentiel d'environ 1 volt. La valeur de la tension V1 appliquée pendant la précharge permet de contrôler cette valeur de potentiel. Puis, pendant la phase d'équilibrage, l'amplificateur suiveur AS est activé et modifie la charge de la ligne de bit en fonction de l'état de la sortie de l'amplificateur différentiel. La modification de charge de la ligne de bit tend à ramener à zéro la sortie de l'amplificateur AD. On obtient ainsi un équilibrage de l'amplificateur différentiel juste avant la phase de lecture. La sortie de l'amplificateur fournit alors pratiquement une tension nulle quelle que soit l'état logique pris par cette sortie à la lecture précédente.

Pendant la phase de lecture l'amplificateur suiveur est désactivé (sortie en haute impédance). L'application d'une tension de lecture sur la ligne de mot a deux effets possibles :
- si la cellule lue est vierge, elle tend à décharger la ligne de bit avec un courant i. Mais le miroir de courant impose un courant k.i (avec k inférieur à 1) dans la ligne de bit, puisque simultanément un courant i circule dans la ligne de référence. Le drain du transistor T1 tend à tomber à un potentiel nul alors que le drain du transistor T2 reste à environ une tension de seuil au dessous de la tension d'alimentation Vcc. L'amplificateur différentiel AD bascule dans un premier état.
- si la cellule lue est programmée, elle ne laisse pas passer de courant de décharge de la ligne de bit, alors que le transistor de recopie T3 tend à imposer un courant de décharge k.i; Le transistor T3 se sature et tend à monter le potentiel du drain de T1 à Vcc. L'amplificateur différentiel AD bascule dans l'autre sens.

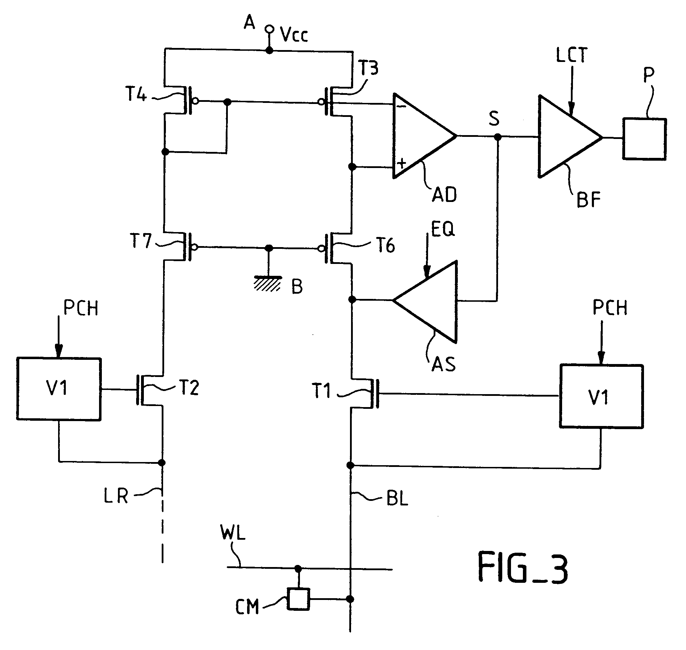

Dans une réalisation améliorée, visible à la figure 3, on a intercalé un transistor supplémentaire T6 entre le drain du transistor de précharge T1 et le drain du transistor de recopie T3; et de même un transistor T7 entre le drain du transistor de précharge T2 et le drain du transistor de référence T4.

Ces transistors sont montés en cascode, c'est-à-dire qu'ils ont leur grille à un potentiel constant qui les rend conducteurs. De préférence ce sont des transistors à canal P dont la grille est au potentiel bas de l'alimentation du circuit (borne de masse B). La sortie de l'amplificateur suiveur AD est reliée au point de jonction du transistor de précharge T1 et du transistor supplémentaire T6.

L'avantage de ces transistors est qu'ils introduisent une grande impédance résistive en dynamique entre la ligne de bit et les entrées de l'amplificateur différentiel. Cette impédance établit un découplage entre le drain du transistor T1 (présentant une forte capacité parasite à cause de la présence de l'amplificateur suiveur) et l'entrée de l'amplificateur différentiel (présentant une faible capacité parasite).

Il en résulte que le déséquilibre de tensions qui apparaît sur la ligne de bit lors de la phase de lecture se retransmet fortement amplifié aux bornes de l'amplificateur différentiel. La lecture est donc accélérée.

## Revendications

1. Mémoire en circuit intégré, comprenant au moins une ligne de bit (BL) à laquelle sont raccordées des cellules de mémoire (CM), et un circuit de lecture connecté à la ligne de bit et comprenant un amplificateur différentiel (AD), des moyens (T1) de précharge de la ligne de bit avant une phase de lecture et des moyens d'équilibrage des potentiels d'entrée de l'amplificateur différentiel avant la phase de lecture, caractérisée en ce que les moyens d'équilibrage comportent un amplificateur suiveur (AS) ayant une entrée reliée à la sortie de l'amplificateur différentiel (AD) et connecté pendant la phase d'équilibrage, mais non pendant la phase de lecture, de telle manière qu'il injecte un courant de charge de la ligne de bit dans un sens tendant à annuler la tension de sortie de l'amplificateur différentiel (AD).

2. Mémoire selon la revendication 1, caractérisée en ce qu'elle comporte
- une ligne de référence (LR) semblable à la ligne de bit,
que les moyens de précharge comprennent un premier transistor (T1) de précharge de la ligne de bit, et un deuxième transistor (T2) de précharge de la ligne de référence,
la sortie de l'amplificateur suiveur (AS) étant connectée pendant la phase d'équilibrage au premier transistor de précharge (T1).

3. Mémoire selon la revendication 2, caractérisée en ce que les transistors de précharge ont leur grille reliée à un potentiel de référence (V1) pendant la phase de précharge.

4. Mémoire selon l'une des revendications 2 et 3, caractérisée en ce que la ligne de bit et la ligne de référence sont reliées à des moyens de comparaison de courant (T3, T4) permettant de comparer, pendant la phase de lecture, le courant de décharge de la ligne de bit et le courant de décharge de la ligne de référence.

5. Mémoire selon la revendication 4, caractérisée en ce que les moyens de comparaison comprennent un transistor de référence (T4) relié à la ligne de référence par l'intermédiaire du deuxième transistor de précharge (T2), et un transistor (T3) de recopie du courant du transistor de référence, le transistor de recopie étant relié à la ligne de bit par l'intermédiaire du premier transistor de précharge (T1).

6. Mémoire selon la revendication 5, caractérisé en ce qu'un premier transistor intermédiaire (T6) ayant sa grille reliée à un potentiel fixe est relié en série entre le transistor de recopie et le premier transistor de précharge.

7. Mémoire selon la revendication 6, caractérisée en ce que le premier transistor intermédiaire (T6) est à canal P et a sa grille reliée à un potentiel d'alimentation bas.

8. Mémoire selon l'une des revendications 6 et 7, caractérisée en ce qu'un deuxième transistor intermédiaire (T7) ayant sa grille reliée au même potentiel fixe est relié en série entre le transistor de référence et le deuxième transistor de précharge.

## Patentansprüche

1. Speicher in integrierter Schaltungsform, umfassend zumindest eine Bitleitung (BL), mit der Speicherzellen (CM) verbunden sind, und eine mit der Bitleitung verbundene und einen Differenzverstärker (AD) beinhaltende Leseschaltung, Mittel (T1) zum Vorladen der Bitleitung vor einer Lesephase, und Mittel zum Ausgleichen der Eingangsspannungen des Differenzverstärkers vor der Lesephase, **dadurch gekennzeichnet**, daß die Mittel zum Ausgleichen einen Begleitverstärker (AS) beinhalten mit einem Eingang, der mit dem Ausgang des Differenzverstärkers (AD) verbunden ist und der während der Ausgleichsphase, nicht jedoch während der Lesephase, so geschaltet ist, daß er einen Bitleitungs-Ladestrom mit einer Richtung injiziert, die auf das Aufheben der Ausgangsspannung des Differenzverstärkers (AD) hinzielt.

2. Speicher nach Anspruch 1, dadurch gekennzeichnet, daß eine der Bitleitung ähnliche Bezugsleitung (LR) vorgesehen ist, und daß die Mittel zum Vorladen einen ersten Vorladetransistor (T1) für die Bitleitung und einen zweiten Vorladetransistor (T2) für die Bezugsleitung umfassen, wobei der Ausgang des Begleitverstärkers (AS) während der Ausgleichsphase mit dem ersten Vorladetransistor (T1) verbunden ist.

3. Speicher nach Anspruch 2, dadurch gekennzeichnet, daß die Basen der Vorladetransistoren während der Vorladephase mit einem Bezugspotential verbunden sind.

4. Speicher nach einem der Ansprüche 2 oder 3, dadurch gekennzeichnet, daß die Bitleitung und die Bezugsleitung mit Stromvergleichsmitteln (T3, T4) verbunden sind, die während der Lesephase das Vergleichen des Bitleitungs-Entladestroms und des Bezugsleitungs-Entladestroms erlauben.

5. Speicher nach Anspruch 4, dadurch gekennzeichnet, daß die Vergleichsmittel einen Bezugstransistor (T4), der über den zweiten Vorladetransistor (T2) mit der Bezugsleitung verbunden ist, und einen Transistor (T3) umfassen, der den Strom des Bezugstransistors spiegelt, wobei der Spiegeltransistor über den ersten Vorladetransistor (T1) mit der Bitleitung verbunden ist.

6. Speicher nach Anspruch 5, dadurch gekennzeichnet, daß ein erster Zwischentransistor (T6), dessen Basis mit einem festen Potential verbunden ist, in Reihe zwischen den Spiegeltransistor und den ersten Vorladetransistor geschaltet ist.

7. Speicher nach Anspruch 6, dadurch gekennzeichnet, daß der erste Zwischentransistor (T6) vom P-Kanal-Typ und seine Basis mit einer niedrigen Speisespannung verbunden ist.

8. Speicher nach einem der Ansprüche 6 oder 7, dadurch gekennzeichnet, daß ein zweiter Zwischentransistor (T7), dessen Basis mit dem selben festen Potential verbunden ist, in Reihe zwischen den Bezugstransistor und den zweiten Vorladetransistor geschaltet ist.

## Claims

1. Integrated circuit memory, comprising at least one bit line (BL) to which memory cells (CM) are connected, and a read circuit connected to the bit line and comprising a differential amplifier (AD), means (T1) for precharging the bit line before a read phase and means for balancing the input potentials of the differential amplifier before the read phase, characterised in that the balancing means include a monitoring amplifier (AS) having an input connected to the output of the differential amplifier (AD) and connected during the balancing phase, but not during the read phase, so that it injects a current charging the bit line in a direction tending to cancel out the output voltage of the differential amplifier (AD).

2. Memory according to Claim 1, characterised in that it includes
- a reference line (LR) similar to the bit line,
in that the precharging means comprise a first transistor (T1) for precharging the bit line and a second transistor (T2) for precharging the reference line,
the output of the monitoring amplifier (AS) being connected during the balancing phase to the first precharging transistor (T1).

3. Memory according to Claim 2, characterised in that the gates of the precharging transistors are connected to a reference potential (V1) during the precharging phase.

4. Memory according to one of Claims 2 and 3, characterised in that the bit line and the reference line are connected to current comparison means (T3, T4) enabling the bit line discharge current and the reference line discharge current to be compared during the read phase.

5. Memory according to Claim 4, characterised in that the comparison means comprise a reference transistor (T4) connected to the reference line by means of the second precharging transistor (T2), and a transistor (T3) for mirroring the reference transistor current, the mirroring transistor being connected to the bit line by means of the first precharging transistor (T1).

6. Memory according to Claim 5, characterised in that a first intermediate transistor (T6) having its gate connected to a fixed potential is connected in series between the mirroring transistor and the first precharging transistor.

7. Memory according to Claim 6, characterised in that the first intermediate transistor (T6) is a p-channel transistor and its gate is connected to a low supply potential.

8. Memory according to one of Claims 6 and 7, characterised in that a second intermediate transistor (T7) having its gate connected to the same fixed potential is connected in series between the reference transistor and the second precharging transistor.
